# EUROPÄISCHE PATENTANMELDUNG

(11) **EP 1 174 298 A2**
(43) Veröffentlichungstag der Anmeldung: **23.01.2002**
(21) Anmeldenummer: 01117589.0
(22) Anmeldetag: 20.07.2001
(51) Int. Cl.: B60J 10/00, B05D 5/08, C23C 16/40, C23C 16/50

(54) **Verfahren zur Verminderung von Störgeräuschen zwischen Bauteilen**

(30) Priorität: 21.07.2000 DE 10035507
(71) Anmelder: Bayerische Motoren Werke Aktiengesellschaft, 80809 München (DE); Fraunhofer-Gesellschaft zur Förderung der angewandten Forschung e.V., 80636 München (DE)
(72) Erfinder: Funk, Jürgen, 81373 München (DE); Hegemann, Dirk, Dr., 70199 Stuttgart (DE); Schulz, Kerstin, 85354 Freising (DE); Barge, Markus, 85764 Oberschleissheim (DE); Gugg, Jürgen, 85354 Freising (DE)
(74) Vertreter: Schernhammer, Herbert

(57) **Zusammenfassung**

Die vorliegende Erfindung betrifft ein Verfahren zur Verminderung oder Verhinderung von Störgeräuschen, die bei der Relativbewegung von zwei in Kontakt tretenden Oberflächenbereichen entstehen. Bei einem erfindungsgemäßen Verfahren wird auf einem oder beiden der in Kontakt tretenden Oberflächenbereiche mittels Plasmaabscheidung eine dünne Schicht abgeschieden, die eine geringere Adhäsionskomponente und eine geringere Deformationskomponente der Reibungskraft aufweist als die unbeschichteten Oberflächenbereiche. Alternativ wird durch Plasmabehandlung die Oberflächenstruktur so verändert, das die oben genannten Eigenschaften erreicht werden.

Durch die Verfahren lassen sich Störgeräusche vermindern oder vollständig unterdrücken, ohne den optischen Eindruck der zugrundeliegenden Oberflächenbereiche zu verändern, was sich bei im Sichtbereich befindlichen Oberflächen positiv auswirkt.

## Beschreibung

### Technisches Anwendungsgebiet

Die vorliegende Erfindung betrifft Verfahren zur Verminderung oder Verhinderung von Störgeräuschen, die bei der Relativbewegung von zwei in Kontakt tretenden Oberflächenbereichen entstehen. Derartige Störgeräusche gehen auf Stick-Slip-Effekte (Ruckgleiten) zurück und treten bei einer Vielzahl gegeneinander bewegter Bauteile von Fahrzeugen auf, beispielsweise bei im Fahrzeuginnenraum befindlichen Leder-, Kunststoff-, Gummioder Metallteilen. Auch in anderen Lebensbereichen werden derartige Geräusche häufig als störend empfunden, wie dies beispielsweise beim Öffnen oder Schließen von Türen in Gebäuden oder von Klappen an Gebrauchsgegenständen der Fall ist.

### Stand der Technik

Gerade auf dem Gebiet der Automobilindustrie werden verstärkt Vorkehrungen getroffen, die Störgeräusche von sich gegeneinander bewegenden Bauteilen im Kraftfahrzeug vermindern sollen. Hierbei werden in der Regel Gleitmittel und Schmiermittel auf die gegeneinander reibenden Bauteile aufgetragen, um den Reibungskoeffizienten der Bauteile herabzusetzen, insbesondere um den Unterschied in der Höhe des Haft- und des Gleitreibungskoeffizienten herabzusetzen. Darüber hinaus sind weitere Maßnahmen, wie das Aufbringen von Filzen, das Vorsehen einer Antiknarznarbe sowie das Aufbringen eines teflonbeschichteten Klebebandes auf einen der gegeneinander reibenden Oberflächenbereiche der Bauteile, zur Verminderung der Störgeräusche bekannt. Eine weitere Technik besteht im Auftragen einer geeigneten reibungsmindernden Lackschicht auf zumindest einen der sich berührenden Oberflächenbereiche.

Der grundsätzliche Nachteil dieser bisher zur Verminderung oder Verhinderung der Störgeräusche eingesetzten Techniken besteht darin, dass die aufgetragenen Zwischenstoffe in der Regel sichtbar sind, so dass es an den jeweiligen Stellen zu einer Veränderung der Farbe, des Glanzgrades und der Haptik der sich gegeneinander bewegenden Bauteile kommt.
Dieser Nachteil kann bei Bauteilen umgangen werden, bei denen eine genaue Abgrenzung zwischen Sichtbereich und Kontaktbereich möglich ist. In diesem Fall kann ein gezielter Auftrag der Zwischenstoffe nur in dem nicht sichtbaren Kontaktbereich der Bauteile erfolgen. Die hierfür notwendige gezielte Auftragung bzw. Abgrenzung ist jedoch technisch sehr aufwendig einzuhalten.
An bestimmten beweglichen Bauteilen, wie beispielsweise Klappen oder Manschetten, ist eine derartige Abgrenzung von vornherein nicht möglich, da der Zwischenstoff abhängig von der Stellung der Bauteilegeöffnet oder geschlossen - wieder sichtbar oder spürbar ist. Ein weiterer Nachteil der bisher eingesetzten Verfahren besteht darin, dass der gezielte Auftrag von Zwischenstoffen an den jeweiligen Oberflächenbereichen der Bauteile sehr kostenintensiv ist, um die erforderliche Prozesssicherheit gewährleisten zu können.

Die Aufgabe der vorliegenden Erfindung besteht darin, ein Verfahren zur Verminderung oder Verhinderung von Störgeräuschen bei der Relativbewegung von zwei in Kontakt tretenden Oberflächenbereichen anzugeben, das die wenigstens einen der oben angeführten Nachteile vermeidet.

### Darstellung der Erfindung

Die Aufgabe wird mit den Verfahren gemäß den Patentansprüchen 1 bis 4 gelöst. Vorteilhafte Ausgestaltungen der Verfahren sind Gegenstand der Unteransprüche.

Bei dem erfindungsgemäßen Verfahren nach Anspruch 1 wird zumindest auf einen der beiden in Kontakt tretenden Oberflächenbereiche der Bauteile mittels Plasmaabscheidung eine dünne Schicht abgeschieden, die eine geringere Adhäsionskomponente und/oder eine geringere Deformationskomponente der Reibungskraft aufweist als die zugrundeliegenden unbeschichteten Oberflächenbereiche. Die Plasmaabscheidung dieser Schicht erfolgt hierbei in den sichtbaren Oberflächenbereichen bevorzugt mit einer derart geringen Dicke, dass sie den optischen Eindruck der sichtbaren Oberflächenbereiche nicht verändert. Beispielsweise wird bei Kunststoffen die Schicht hierfür mit einer Dicke zwischen 10 und 50 nm abgeschieden. Außerhalb des Sichtbereichs sind beispielsweise Schichtstärken von etwa 100 nm vorstellbar.

Gemäß Anspruch 2 ist es alternativ möglich, die Oberflächenstruktur durch eine Plasmabehandlung so zu verändern, dass die behandelte Oberfläche eine geringere Adhäsionskomponente und/oder eine geringere Deformationskomponente der Reibungskraft aufweist als die zugrundeliegenden unbehandelten Oberflächenbereiche. Die Plasmabehandlung erfolgt ohne nennenswerte Abscheidung von Material.

Bei den Verfahren nach Anspruch 1 und 2 wird mit anderen Worten ein Zustand angestrebt, bei dem sich die in Kontakt stehenden Oberflächen mit geringeren Reibungswiderständen ohne Stick-Slip-Effekte ungehindert gegeneinander bewegen können ("optimales Gleiten").

In analoger Weise wird bei den Verfahren nach Anspruch 3 und 4 die Adhäsionskomponente und/oder die Deformationskomponente erhöht. Hiermit wird idealerweise ein Zustand angestrebt, bei dem zwischen den in Kontakt stehenden Oberflächen keine Relativbewegungen stattfinden ("optimales Haften") und somit keine Geräusche durch Stick-Slip-Effekte auftreten.

Hierbei ist es sinnvoll, bei härteren Oberflächen, die grundsätzlich weniger zum Haften neigen, die Adhäsionskomponente und/oder die Deformationskomponente weiter zu verringern und damit die Neigung der Oberflächen, aneinander zu haften, ebenfalls zu verringern. Durch diese Maßnahme erfolgt eine Annäherung an den Zustand "optimales Gleiten".

Umgekehrt ist es bei weicheren, zum Haften neigenden Oberflächen sinnvoll, die Adhäsionskomponente und/oder die Deformationskomponente weiter zu erhöhen und damit gezielt Relativbewegungen zwischen den in Kontakt stehenden Oberflächenbereichen zu vermeiden. Durch diese Maßnahme erfolgt eine Annäherung an den Zustand "optimales Haften".

In beiden Fällen ("optimales Gleiten" bzw. "optimales Haften") werden gegenüber unbeschichteten oder unbehandelten Oberflächen Störgeräusche vermindert oder vollständig verhindert.

Gemäß Anspruch 5 wird die Deformationskomponente deutlich erhöht, um im Kontaktbereich einen geräuscharmen oder geräuschfreien Ausgleich von Relativbewegungen zu erzielen, indem sich zumindest einer der in Kontakt stehenden Oberflächenbereiche bei der Relativbewegung verformt. Beispielsweise kann bei Leder durch eine deutliche Erhöhung der Deformationskomponente eine wildlederartige Oberfläche erzeugt werden, bei der durch die Beweglichkeit der obersten Oberflächenschicht Relativbewegungen ohne Geräuschentwicklung ausgeglichen werden können.

Prinzipiell ist es bei allen erfindungsgemäßen Verfahren möglich, nur eine der beteiligten Kontaktoberflächen zu verändern. So kann bei Kontaktpartnern mit einer weicheren Oberfläche einerseits und einer härteren Oberfläche andererseits beispielsweise nach Anspruch 5 nur die Deformationskomponente der weicheren Oberfläche deutlich erhöht werden, um hierdurch einen geräuscharmen oder geräuschfreien Ausgleich von Relativbewegungen zu ermöglichen.

Grundsätzlich wird die Technik der Plasmaabscheidung oder Plasmabehandlung in anderen Bereichen der Technik eingesetzt, um die Oberflächeneigenschaften von Bauteilen gezielt zu verändern. Für die plasmagestützte Abscheidung oder Behandlung bzw. Plasmapolymerisation sind zahlreiche Reaktorgeometrien bekannt wie sie auch - abhängig von den Dimensionen der zu beschichtenden/behandelnden Bauteile - beim vorliegenden Verfahren eingesetzt werden können. Aus anderen Anwendungsbereichen ist es auch bekannt, den Reibungskoeffizienten von Bauteilen durch eine Beschichtung/Behandlung im Niederdruckplasma zu senken. So werden beispielsweise Hartstoffschichten wie DLC (diamond-like carbon) zur Reibungsminderung und als Verschleißschutz für Werkzeuge eingesetzt. Eine Anwendung einer derartigen Hartstoffbeschichtung zur Verminderung von Störgeräuschen führt jedoch nicht zum gewünschten Ergebnis. Vielmehr zeigen Versuche an einem speziell entwickelten Stick-Slip-Prüfstand, dass derart reibungsmindernde Hartstoffschichten nicht zu einer Verminderung der Störgeräusche führen. Auch eine Aufbringung von hydrophoben Schichten zur Verringerung der Adhäsion führte - zumindest bei ABS-PC als Bauteilmaterial - mit den bekannten Techniken nicht zu einer deutlichen Verringerung der Störgeräusche, so dass auch dieser Ansatz bei der vorliegenden Problematik nicht zum Erfolg führt.

Die Erfinder der vorliegenden Verfahren haben dennoch erkannt, dass sich die Störgeräusche durch Plasmaabscheidung einer Schicht oder durch Veränderung der Oberflächenstruktur durch Plasmabehandlung vermindern lassen, wenn die Plasmabedingungen bei der Abscheidung oder Behandlung geeignet gewählt werden. Hierbei wurde insbesondere beachtet, dass sich die Reibungskraft F_{R} der beiden gegeneinander reibenden Oberflächenbereiche aus zwei Anteilen zusammensetzt, einer Adhäsionskomponente F_{A} und einer Deformationskomponente F_{D}, wobei F_{R} = F_{A} + F_{D}. Für die Plasmaabscheidung oder -Behandlung ist es hierbei wesentlich, dass die Adhäsionskomponente F_{A} und die Deformationskomponente F_{D} der abgeschiedenen Schicht bzw. der veränderten Oberfläche entweder in der Summe kleiner (Annäherung an den Zustand "optimales Gleiten" - vor allem bei härteren Oberflächenbereichen) oder in der Summe größer (Annäherung an den Zustand "optimales Haften" - vor allem bei weicheren Oberflächenbereichen) sein müssen als die Summe der entsprechenden Komponenten der Oberflächenbereiche vor der Abscheidung oder Behandlung.

Die Annäherung beispielsweise an den Zustand "optimales Gleiten" (Ansprüche 1 und 2) erfordert, insbesondere im Hinblick auf die bisher nicht beachtete Deformationskomponente F_{D}, eine gezielte Einstellung der Parameter bei der Plasmaabscheidung oder -Behandlung. Grundsätzlich ist hierbei eine möglichst geringe Deformationskomponente, d.h. geringe Scherfestigkeit und möglichst hohe Duktilität der Schicht bzw. Oberfläche von Vorteil. Der Fachmann auf dem Gebiet der Plasmatechnologie ist hierbei in der Lage, die zur Plasmaabscheidung oder -Behandlung eingesetzten Materialien durch gezielte Einstellung der Plasmaparameter in Form einer dünnen Schicht mit der gewünschten Quervernetzung und Verknäulung abzuscheiden bzw. die Kontaktoberflächen entsprechend zu verändern.

So wird beispielsweise durch Anrauhen nur einer der beiden Kontaktoberflächen eines harten Oberflächenmaterials die wirksame Kontaktfläche der beiden sich berührenden Oberflächen verringert und somit die Stick-Slip-Neigung reduziert. Durch das nur einseitige Anrauhen wird dabei ein Verhaken der beiden Kontaktoberflächen verhindert.

Besonders gute Ergebnisse lassen sich beispielsweise durch Plasmaabscheidung einer dünnen Schicht erzielen, bei der die Länge der Kettenstücke zwischen 5 und 100 Wiederholeinheiten liegt. Hierzu müssen die Plasmaparameter derart eingestellt werden, dass bereits im Plasmavolumen eine Plasmapolymerisation stattfindet, die ausreichend lange Polymerketten zwischen 5 und 100, vorzugsweise um 10, Wiederholeinheiten erzeugt, die dann auf dem Bauteil während der Abscheidung hinreichend quervernetzt werden. Eine derart abgeschiedene Schicht weist eine ausreichende Stabilität bei guten knarzverhindernden Eigenschaften auf. Hierbei ist insbesondere der Einsatz einer Reaktorgeometrie von Vorteil, die milde Plasmabedingungen während des Schichtwachstums ermöglicht, d.h. bei einer niedrigen Leistungsdichte betrieben werden kann.
Die Wiederholeinheit kann durch chemische Analyse der abgeschiedenen Schicht mittels Elektronenspektroskopie ermittelt werden. Im Beispiel von Siloxanen als abzuscheidende Schicht ist die Wiederholeinheit als Quotient aus (atomarem) Siliziumanteil und dem Betrag der Differenz aus Silizium- und Sauerstoffanteil definiert.

Die besten Ergebnisse bei der Plasmabehandlung erhält man bei einer Reaktoreinstellung, welche die Oberflächenstruktur so verändert, das die Kontaktoberfläche so gering wie möglich wird.

Die Plasmaabscheidung erfolgt bei Kunststoffen vorzugsweise durch Einsatz eines HMDSO-Plasmas, da eine derart mit diesem Material abgeschiedene Schicht neben der knarzmindernden Wirkung zusätzlich eine besondere Verschleißfestigkeit aufweist. Selbstverständlich lassen sich, insbesondere bei Oberflächen aus anderen Materialien, jedoch auch andere Materialien zur Plasmaabscheidung einsetzen, wie beispielsweise Polyethylen oder Polytetrafluorethylen. Selbstverständlich müssen auch in diesem Fall die Plasmaparameter Leistung, Druck und Monomerfluss in der Art eingestellt werden, dass die Deformationskomponente der abgeschiedenen Schicht die obige Bedingung erfüllt.

Die Art der Plasmabehandlung ist materialabhängig.

Mit den vorliegenden Verfahren lassen sich Störgeräusche zwischen zwei in Kontakt stehenden Oberflächenbereichen, die sich relativ zu einander bewegen, deutlich verringern, ohne den optischen Eindruck dieser Oberflächenbereiche zu verändern. Selbstverständlich kann auch außerhalb des Sichtbereiches eine Plasmabeschichtung oder -Behandlung vorgenommen werden, ohne hier Rücksicht auf das optische Erscheinungsbild der Oberflächen nehmen zu müssen.

Die beispielsweise ca. 50 nm dicke abgeschiedene Schicht bei einer Plasmabeschichtung ist elastisch, duktil, farblos und kratzfest. Sie gleicht zudem Oberflächenrauhigkeiten aus. Mit einer entsprechenden hochskalierten Reaktortechnik lassen sich auch komplexe Bauteilgeometrien problemlos beschichten bzw. verändern. Die Beschichtung hat im Vergleich zu den bisher in diesem Bereich eingesetzten Techniken den Vorteil, dass sie unsichtbar, nicht fühlbar, kratzfest und temperaturstabil ist. Weiterhin sind keine Nacharbeiten an den gemäß dem Verfahren behandelten Bauteilen erforderlich und der Beschichtungsprozess an sich ist kostengünstig durchführbar. Die Beschichtung haftet bei entsprechender Plasmavorbehandlung auf allen Substraten.

Veränderte Oberflächenstrukturen nach einer Plasmabehandlung dürfen die Optik und Haptik im Sichtbereich ebenfalls nicht verändern und dürfen durch die auftretenden mechanischen Belastungen nicht verändert oder beschädigt werden.

Selbstverständlich wird bei der Plasmaabscheidung oder -Behandlung an Kunststoffteilen ein Niederdruck-bzw. Niedertemperaturplasma eingesetzt. Für andere Bauteilmaterialien bzw. Anwendungsbereiche zur Störgeräuschverminderung oder -Verhinderung lässt sich jedoch auch ein Hochtemperaturplasma einsetzen. Als Anwendungsgebiete kommt hierbei selbstverständlich nicht nur die Automobilindustrie, sondern auch andere, beispielsweise in der Beschreibungseinleitung genannte, Anwendungsgebiete in Frage, bei denen durch gegeneinander Bewegen von Oberflächenbereichen störende Geräusche auftreten.

Soweit sich die obenstehenden Erläuterungen nur auf die Annäherung an den Zustand "optimales Gleiten" (Ansprüche 1 und 2) beziehen, gelten die Ausführungen sinngemäß in umgekehrter Weise für die Annäherung an den Zustand "optimales Haften" (Ansprüche 3 und 4).

Die vorliegenden Verfahren werden nachfolgend anhand eines Ausführungsbeispiels ohne Beschränkung des allgemeinen Erfindungsgedankens nochmals kurz erläutert.

### Wege zur Ausführung der Erfindung

Die Erfindung wird im nachfolgenden Ausführungsbeispiel zur Verminderung von Störgeräuschen eingesetzt, die zwischen einem Bauteil aus einem PUR und einem Bauteil aus einem anderen Polymer, wie beispielsweise ABS/PC, bestehen. Die Beschichtung erfolgt in einem üblichen Plasmareaktor in einem durch Hochfrequenz angeregten Plasmaprozess. Die Funktionsweise sowie der Aufbau derartiger Plasmareaktoren sind dem Fachmann aus der Fachliteratur bekannt. Die Art der Leistungseinbringung in den Reaktor spielt bei dem vorliegenden Verfahren keine Rolle.
Als Kontrollparameter für die Plasmaabscheidung oder -Behandlung dienen die Hochfrequenz-Leistung, der Druck im Reaktor sowie der Monomerfluss des eingesetzten Materials, wobei der interessierende Parameterraum durch die Größen Leistung/Fluss (Yasuda-Faktor), Druck/Fluss (Verweildauer) und Leistung/Druck aufgespannt wird. Weitere Voraussetzungen sind eine physikalisch und chemisch homogene Plasmazone sowie im vorliegenden Beispiel eine niedrige Bauteil- bzw. Substrattemperatur zwischen 30 und 100°C. Die Dicke der abgeschiedenen Schicht wird über die Behandlungsdauer eingestellt. Die Oberflächenprozesse, d.h. das Schichtwachstum, werden über das Plasmapotential kontrolliert, um eine hinreichende Vernetzung der Schicht zu erreichen.

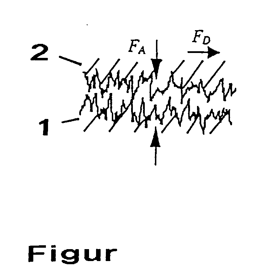

Bei dem vorliegenden Verfahren wird die Schicht derart abgeschieden, dass ihre Adhäsionskomponente F_{A} und ihre Deformationskomponente F_{D} geringer sind als die entsprechenden Komponenten der zu beschichtenden Oberflächenbereiche. Die Wirkung der Adhäsions- und der Deformationskomponente F_{A} bzw. F_{D} an der Grenzfläche ist anhand der Fig. 1 zwischen zwei Oberflächenbereichen 1 und 2 durch Pfeile veranschaulicht. Die abgeschiedene dünne Schicht muss hierbei insbesondere eine niedrige Deformationskomponente, d.h. geringe Scherfestigkeit und hohe Duktilität, besitzen. Dies wird durch die entsprechende Wahl der Plasmaparameter erreicht, die zu einer geeigneten Linearisierung der Ausgangssubstanz (Plasmapolymerisation) führt.

Bei dem vorliegenden Beispiel beträgt die Anregungsfrequenz 13,56 MHz. Das ABS/PC-Substrat wird zur Vorbehandlung zunächst in den Plasmareaktor eingebracht und für 5 Sekunden bei einem Druck von 0,25 mbar (0,25*10² Pa) und bei einer Anregungsleistung von 300 W in einem Heliumplasma aktiviert. Anschließend erfolgt die Plasmabeschichtung gemäß dem vorliegenden Verfahren. Hierfür wird das Substrat direkt im Anschluss an die Vorbehandlung für 30 Sekunden einem reinen HMDSO-Plasma ausgesetzt, wobei der Druck 0,15 mbar (0,15*10² Pa), die Leistung 95 W und der Monomerfluss 90 sccm (standard cubic centimeter per minute) betragen. Als Resultat wird eine 20 nm dicke Siloxanschicht auf dem ABS/PC-Substrat abgeschieden, die eine Wiederholeinheit von 10 aufweist.

Die in diesem Beispiel mit dem Verfahren abgeschiedene Schicht verhindert die Entstehung von Störgeräuschen gegenüber einem PUR-Reibpartner. Durch die sehr geringe Dicke von nur 20 nm ergibt sich keinerlei Veränderung des optischen Eindrucks sowie der Haptik des zugrundeliegenden Substrats.

Bei der Plasmabehandlung wird beispielsweise eine Kunststoffoberfläche so lange dem Plasmastrom ausgesetzt, bis ihre Oberfläche deutlich rauer wird. Dadurch kann die Kontaktoberfläche derart verringert werden, das es bereits bei kleineren, kaum wahrnehmbaren Strukturänderungen zu einer deutlichen Verminderung der Störgeräusche kommt.

## Patentansprüche

1. Verfahren zur Verminderung oder Verhinderung von Störgeräuschen, die bei der Relativbewegung von zwei in Kontakt tretenden Oberflächenbereichen entstehen,
bei dem auf einem oder beiden der in Kontakt tretenden Oberflächenbereiche mittels Plasmaabscheidung eine Schicht abgeschieden wird, die eine geringere Adhäsionskomponente und/oder eine geringere Deformationskomponente der Reibungskraft als die unbeschichteten Oberflächenbereiche aufweist.

2. Verfahren zur Verminderung oder Verhinderung von Störgeräuschen, die bei der Relativbewegung von zwei in Kontakt tretenden Oberflächenbereichen entstehen,
bei dem auf einem oder beiden der in Kontakt tretenden Oberflächenbereiche mittels Plasmabehandlung die Oberfläche so verändert wird, dass der behandelte Oberflächenbereich eine geringere Adhäsionskomponente und/oder eine geringere Deformationskomponente der Reibungskraft als die unbehandelten Oberflächenbereiche aufweist.

3. Verfahren zur Verminderung oder Verhinderung von Störgeräuschen, die bei der Relativbewegung von zwei in Kontakt tretenden Oberflächenbereichen entstehen,
bei dem auf einem oder beiden der in Kontakt tretenden Oberflächenbereiche mittels Plasmaabscheidung eine Schicht abgeschieden wird, die eine höhere Adhäsionskomponente und/oder eine höhere Deformationskomponente der Reibungskraft als die unbeschichteten Oberflächenbereiche aufweist.

4. Verfahren zur Verminderung oder Verhinderung von Störgeräuschen, die bei der Relativbewegung von zwei in Kontakt tretenden Oberflächenbereichen entstehen,
bei dem auf einem oder beiden der in Kontakt tretenden Oberflächenbereiche mittels Plasmabehandlung die Oberfläche so verändert wird, dass der behandelte Oberflächenbereich eine höhere Adhäsionskomponente und/oder eine höhere Deformationskomponente der Reibungskraft als die unbehandelten Oberflächenbereiche aufweist.

5. Verfahren nach Anspruch 4,
**dadurch gekennzeichnet, dass** die Oberfläche so verändert wird, dass der behandelte Oberflächenbereich eine deutlich höhere Deformationskomponente der Reibungskraft als die unbehandelten Oberflächenbereiche aufweist.

6. Verfahren nach Anspruch 1 und/oder 3,
**dadurch gekennzeichnet,**
**dass** die Schicht mit einer Dicke zwischen 10 und 50 nm abgeschieden wird.

7. Verfahren nach Anspruch 1 und/oder 3 und/oder 6,
**dadurch gekennzeichnet,**
**dass** bei der Plasmaabscheidung die Prozessparameter derart eingestellt werden, dass die aufgebrachte Schicht einen Vernetzungsgrad mit einer Wiederholeinheit aufweist, die im Bereich zwischen 5 und 100 liegt.

8. Verfahren nach einem der vorgenannten Ansprüche,
**dadurch gekennzeichnet,**
**dass** die Plasmaabscheidung durch Erzeugung eines HMDSO-Plasmas erfolgt.

9. Verfahren nach Anspruch 8,
**dadurch gekennzeichnet,**
**dass** bei der Plasmaabscheidung mit HMDSO die Prozessparameter derart eingestellt werden, dass die aufgebrachte dünne Schicht eine Wiederholeinheit von ca. 10 aufweist.

10. Verfahren nach einem der vorgenannten Ansprüche,
**dadurch gekennzeichnet,**
**dass** die Plasmaabscheidung bzw. -Behandlung mit einem Niederdruckplasma erfolgt.
